**Europäisches Patentamt**

**European Patent Office**

**Office européen des brevets**

(19)

(11) Veröffentlichungsnummer : **0 381 082 B1**

(12)

# EUROPÄISCHE PATENTSCHRIFT

(45) Veröffentlichungstag der Patentschrift :
**08.04.92 Patentblatt 92/15**

(51) Int. Cl.$^5$ : **B05D 1/18**

(21) Anmeldenummer : **90101609.7**

(22) Anmeldetag : **26.01.90**

(54) **Verfahren zum Lackieren einer Baugruppe in einem Gehäuse.**

(30) Priorität : **31.01.89 DE 3902841**
**31.01.89 DE 8901057 U**

(43) Veröffentlichungstag der Anmeldung :
**08.08.90 Patentblatt 90/32**

(45) Bekanntmachung des Hinweises auf die
Patenterteilung :
**08.04.92 Patentblatt 92/15**

(84) Benannte Vertragsstaaten :
**DE FR GB IT**

(56) Entgegenhaltungen :
**EP-A- 0 100 474**
**CH-A- 667 019**

(56) Entgegenhaltungen :
**DD-A- 24 804**
**GB-A- 625 039**
**GB-A- 670 548**
**GB-A- 2 180 473**
**US-A- 4 479 986**

(73) Patentinhaber : **SIEMENS**
**AKTIENGESELLSCHAFT**
**Wittelsbacherplatz 2**
**W-8000 München 2 (DE)**

(72) Erfinder : **Meyer, Norbert**
**Gartenstrasse 7 B**
**W-8411 Neudorf/Pettendorf (DE)**
Erfinder : **Haupt, Günter**
**Hollerweg 11 A**
**W-8400 Regensburg-Keilberg (DE)**

## Beschreibung

Die Erfindung betrifft ein Verfahren zum Lackieren einer aus elektrischen und/oder mechanischen Bauelementen bestehenden Baugruppe in einem Gehäuser, gemäß dem Oberbegriff des Anspruchs 1.

Die Erfindung betrifft auch eine Vorrichtung zur Durchführung dieses verfahrens, gemäß dem Oberbegriff des Anspruchs 7.

Elektrische und/oder mechanische Bauelemente oder Baugruppen werden in der Regel mit einem Schutzlack überzogen, wenn sie einer feuchten oder aggressiven Atmosphäre ausgesetzt werden sollen. Metallische Oberflächen und Anschlußdrähte von Bauelementen sowie Leiterbahnen auf Leiterplatten und Lötverbindungen werden auf diese Weise gegen Korrosion und Kriechströme geschützt.

In den Dokumenten GB-A-670 548 und GB-A-625 039 sind Verfahren zum Tränken bzw. Lackieren von Bauelementen beschrieben. Dabei wird das Bauelement in einem geschlossenen Behälter in eine Flüssigkeit bzw. ein Isolierlack eingetaucht. Nach einer Einwirkzeit werden die Flüssigkeiten abgesaugt und das Bauelement aus dem Behälter zur weiteren Behandlung entfernt. Diese Verfahren haben den Nachteil, daß die Bauelemente, bevor sie in ein Gehäuse eingebaut werden, in einen eigenen Behälter getränkt bzw. lackiert werden müssen.

Bisher wurden also die Baugruppen nach Fertigstellung und vor dem Einbau in ein Gehäuse, also in einem frühen Fertigungsstadium, lackiert. Vor dem Lackieren mußten nicht zu lackierende Bereiche, beispielsweise mit dem Gehäuse zu verbindende Masseanschlüsse, Steckkontakte und sonstige elektrische Anschlüsse sowie Wärmeleitflächen von wärmeerzeugenden Bauelementen, wie Leistungshalbleitern und dergleichen, abgedeckt werden. Dies geschah in der Regel mit Klebeband oder Abdecklack, um diese Bereiche nach dem Lackieren auf einfache Weise wieder freilegen zu können.

Das Lackieren erfolgte üblicherweise in zentral aufgestellten Lackiereinrichtungen innerhalb der Fertigungsräume und erforderte einen hohen Aufwand (geschlossene Spritzkabinen, Absauganlagen, ungünstiger Materialfluß mit langen Wegen und hohen Durchlaufzeiten, Lackierrobotor für schwierige Lackiervorgänge).

Es kam dabei oft vor, daß sich Abdeckungen vor dem Lackieren lösten und anschließend ungewollt lackierte Bereiche mühsam gereinigt werden mußten. Ein weiterer großer Nachteil war, daß lackierte Baugruppen, die sich als fehlerhaft erwiesen, nicht repariert werden durften, sondern verworfen werden mußten. Dadurch entstanden unnötig hohe Kosten.

Die Aufgabe der Erfindung besteht darin, das Lackieren einer Baugruppe so durchzuführen, daß der erforderliche Aufwand sowie die Materialwege und Durchlaufzeiten reduziert werden, der Lackiervorgang in einem möglichst späten Fertigungsstadium erfolgen kann und hohe Ausschüsse vermieden werden.

Aufgabe der Erfindung ist es auch, eine für die Durchführung dieses Verfahrens besonders geeignete Vorrichtung zu schaffen.

Diese Aufgabe wird durch die in den Patenansprüchen 1 und 7 genannten Merkmale gelöst.

Die besonderen Vorteile des erfindungsgemäßen Verfahrens sind folgende:

– Es werden nur fertigmontierte und geprüfte Baugruppen lackiert, nicht funktionsfähige Baugruppen können vor dem Lackieren repariert werden;

– Masseverbindungen zwischen Baugruppe und Gehäuse werden ebenfalls lackiert und damit geschützt;

– es sind keine Abdeckungen nicht zu lackierender Bereiche erforderlich;

– es können kleine und handliche Lackiereinrichtungen an jedem Punkt der Fertigungslinie eingesetzt werden;

– es entfallen zusätzliche Transportwege;

– Investitionskosten können gesenkt werden.

Vorteilhafte Weiterbildungen des erfindungsgemäßen Verfahrens sind den Unteransprüchen 2 bis 6 zu entnehmen.

Die Vorrichtung zur Durchführung des erfindungsgemäßen Verfahrens weist die Herhmale gemäß Anspruch 7 auf.

Eine vorteilhafte Ausgestaltung des Gehäuses, um die Dichtigkeit im Bereich des Deckels zu gewährleisten, ist dem Anspruch 8 zu entnehmen.

Bei dem Gehäuse wird gemäß Anspruch 9 vorteilhaft erreicht, daß die Leistungshalbleiter mittels Federkraft an die Gehäuseaußenwand gedrückt werden, ohne daß ein aufwendiges Anschrauben der Leistungshalbleiter am Gehäuse und ein Isolieren der Schraube (Kunststoffschraube) notwendig ist. Dieser Vorteil macht sich umso stärker bemerkbar, je mehr Leistungshalbleiter auf der Baugruppe vorhanden sind.

Die Erfindung wird am Beispiel einer in ein Gehäuse eingebauten Baugruppe anhand der Zeichnung näher erläutert.

Es zeigen:

Figur 1 einen Längsschnitt durch das Gehäuse entlang der Linie I-I in Figur 2 (mit aufgesetztem Deckel),

Figur 2 eine Aufsicht auf das Gehäuse in Richtung des Pfeiles II in Figur 1 bei geöffnetem Deckel,
Figur 3 eine Seitenansicht auf den Steckverbinder in Richtung des Pfeiles III in Figur 2 und 4,
Figur 4 einen Querschnitt durch das Gehäuse entlang Linie IV-IV in Figur 1 und 2 und
Figur 5 einen vergrößerten Ausschnitt der Deckel-Gehäuseverbindung (Bereich V in Figur 4).

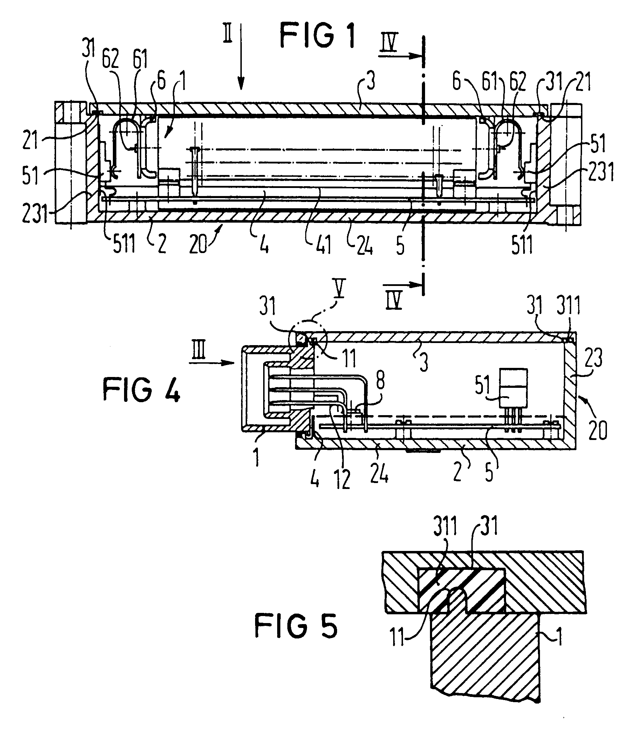

In Figur 1 erkennt man das Gehäuse 2 mit aufgesetztem Deckel 3. Im Gehäuse 2 ist eine Leiterplatte 5 eingesetzt, auf welcher Leistungshalbleiter 51 befestigt sind. Die Leistungshalbleiter werden über eine Feder 61, welche an einem Federhalter 6 befestigt ist, gegen die Querwand 231 gedrückt. Zwischen der Querwand 231 und dem Leistunghalbleiter 51 befindet sich eine Isolation 511. Zwischen Leiterplatte 5 und einem Steckverbinder 1 erkennt man den Steg 4 mit der Oberkante 41.

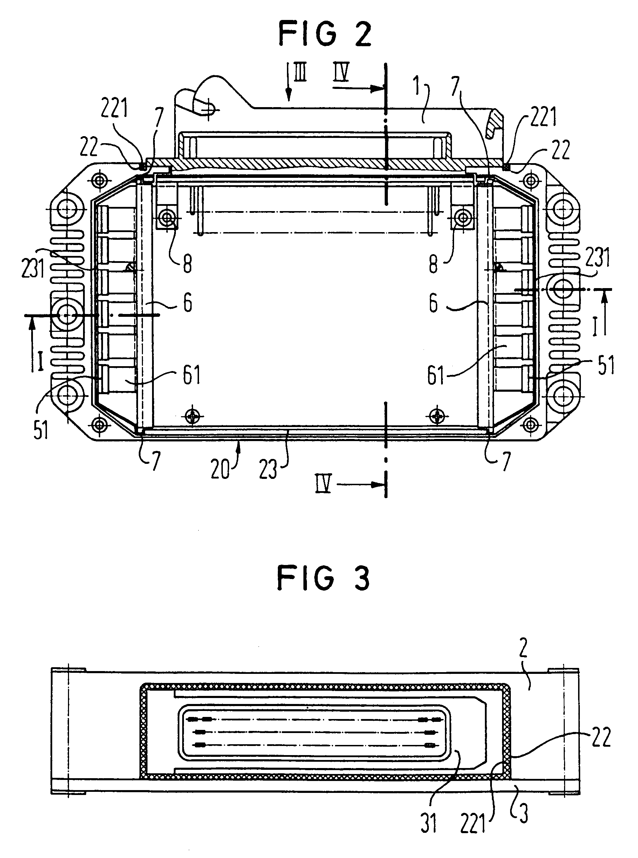

In Figur 2 sieht man Haltenuten 7 in den Längswänden 23, in welche die Federhalter 6 eingesetzt sind. Die Gehäusenut 22, die um den Steckverbinder 1 verläuft, ist mit einer elastischen Vergußmasse 221 gefüllt.

Zur Verdeutlichung ist in Figur 3 eine Seitenansicht mit bereits aus Figur 1 und Figur 2 bekannten Bezugszeichen dargestellt.

Figur 4 zeigt neben den in den vorangegangenen Figuren bereits erläuterten Elementen einen Steg 4, welcher vom Boden 24 absteht und über die gesamte Breite des Gehäuses 2 in geringem Abstand hinter dem Steckverbinder 1 zwischen den Querwänden 231 verläuft: Steg 4, Querwände 231, eine Längswand 23 und der Boden 24 bilden so eine Wanne zur vorübergehenden Aufnahme von Lack. Die Oberkante 41 des Steges 4 liegt unterhalb des parallel zur Leiterplatte 5 verlaufenden Teils der Anschlußdrähte 12, aber oberhalb der Leiterplatte 5. Dieser Steg 4 ermöglicht es daher, das Unterteil 20 des Gehäuses 2 mit einem nicht gezeichneten Lack bis auf die Höhe der gestrichelt eingezeichneten, der Oberkante 41 entsprechenden Linie aufzufüllen. Dadurch ist sichergestellt, daß insbesondere die korrosionsempfindlichen Teile der Leiterplatte 5 mit einer Schutzlackschicht benetzt sind.

Um ein Benetzen aller innerhalb der Wanne liegenden Teile, insbesondere der Leiterplattenunterseite, sicherzustellen, wird das Gehäuse 2 beim Lackeinfüllen etwas geneigt und gerüttelt. Dadurch werden Luftblasen am Entstehen gehindert bzw. beseitigt. Zu demselben Zweck kann das Lackeinfüllen unter Vakuum oder unter Druck erfolgen oder die eingefüllte Lackmenge mit Ultraschall beaufschlagt werden.

Nach einer ausreichenden Benetzung der in der Wanne befindlichen Teile wird der überschüssige Lack, wenn dies möglich ist und dadurch keine nicht zu lackierenden Teile erreicht werden, einfach durch Kippen des Gehäuses 2 abgegossen, andernfalls abgesaugt. Anschließend wird in einem letzten Arbeitsgang das Gehäuse mit dem Deckel 3 verschlossen.

Die Verbindung zwischen Gehäuse 2 und Deckel 3 ist durch die in Figur 5 im Detail vergrößert dargestellte Konstruktion abgedichtet. Im Deckel 3 befindet sich eine umlaufende Deckelnut 31, welche mit Vergußmasse 331 ausgefüllt ist: An drei Seiten des Deckels ragt eine Gehäuserippe 21 in die Dichtmasse 311; eine an dem Steckverbinder 1 angebrachte Rippe 11 drückt an der vierten Seite in die Dichtmasse 311, wodurch die Verbindung zwischen Deckel 3 und Gehäuse 2 umlaufend abgedichtet ist.

## Patentansprüche

1. Verfahren zum Lackieren einer aus elektrischen und/oder mechanischen Beauelementen bestehenden Baugruppe (1;5;51) in einem Gehäuse, wobei die Baugruppe in dem Gehäusse (2) eingebaut ist sowie zu lackierende und nicht zu lackierende Teile aufweist,
**dadurch gekennzeichnet,**
– daß die Baugruppe in einem wannenförmigen Gehäuseteil so angeordnet wird, daß sich die zu lackierenden Teile unterhalb und die nicht zu lackierenden Teile oberhalb eines Lackierpegels des Gehäuseteils befinden,
– daß Lack (9) bis zu dem Lackierpegel in das Gehäuseteil gefüllt wird, und
– daß anschließend überschüssiger Lack (9) entfernt wird.

2. Verfahren nach Anspruch 1,
**dadurch gekennzeichnet,**
daß das Gehäuse (2) beim Lackeinfüllen gerüttelt wird.

3. Verfahren nach Anspruch 1,
**dadurch gekennzeichnet,**
daß das Gehäuse (2) beim Lackeinfüllen einem Vakuum ausgesetzt wird.

4. Verfahren nach Anspruch 1,
**dadurch gekennzeichnet,**
daß die eingefüllte Lackmenge mit Ultraschall beaufschlagt wird.

5. Verfahren nach Anspruch 1,

**dadurch gekennzeichnet,**
daß der Lack (9) unter Druck eingefüllt wird.

6. Verfahren nach Anspruch 1,
**dadurch gekennzeichnet,**
daß überschüssiger Lack (9) abgesaugt wird.

7. Vorrichtung zur Durchführung des Verfahrens nach Anspruch 1 mit einem Gehäuse (2) zur Aufnahme einer aus elektrischen und/oder mechanischen Bauelementen bestehenden Baugruppe, die unter anderem einen Steckverbinder (1), eine Leiterplatte (5) und Leistungshalbleiter (51) aufweist,
– mit einem Unterteil (20) mit einem Boden (24), Längswänden (23) und Querwänden (231),
– mit einer Ausnehmung in oder anstelle einer der Längswände (23), in welcher der Steckverbinder (1) sitzt, und
– mit einem Deckel (3),
**dadurch gekennzeichnet, daß**
– im Bereich der Ausnehmung ein Steg (4), der sich zwischen den Querwänden (231) erstreckt, zusammen mit dem Boden (24), den Querwänden (231) und einer Längswand (23) eine Wanne bildet, in der zu lackierende Teile der Baugruppe angeordnet sind.

8. Vorrichtung nach Anspruch 7,
**dadurch gekennzeichnet, daß**
– der Deckel eine umlaufende, mit elastischer Dichtmasse (311) gefüllte Deckelnut (31) aufweist,
– die Oberseiten der Quer- und Längswände (23, 231) eine umlaufende Rippe (21) und der Steckverbinder (1) an der Berührungsstelle mit dem Deckel (3) eine Rippe (11) haben und
– diese Rippen (11, 21) in die Dichtmasse (311) ragen.

9. Vorrichtung nach Anspruch 7,
**dadurch gekennzeichnet, daß**
– die beiden Längswände (23) jeweils zwei senkrecht zum Boden (24) verlaufende Haltenuten (7) haben, die jeweils gleichen Abstand von den Querwanden (231) haben,
– parallel zu den Querwanden (231) zwei Federhalter (6) mit Federn (61) in den Haltenuten (7) stecken, und
– die Federn (61) die Leistungshalbleiter (51) an die Querwände (231) drücken.

## Claims

1. Method of lacquering a module (1; 5; 51) consisting of electrical and/or mechanical components in a housing, the module being built into the housing (2) and incorporating both parts to be lacquered and parts not to be lacquered, characterised
– in that the module is mounted in a trough-shaped housing part in such a way that the parts to be laquered are below a lacquering level of the housing part and those not to be lacquered are above it,
– in that lacquer (9) is poured into the housing part up to the lacquering level, and
– in that excess lacquer (9) is subsequently removed.

2. Method according to Claim 1, characterised in that the housing (2) is shaken while the lacquer is being poured in.

3. Method according to Claim 1, characterised in that the housing (2) is exposed to a vacuum while the lacquer is being poured in.

4. Method according to Claim 1, characterised in that the quantity of lacquer poured in is ultrasonically irradiated.

5. Method according to Claim 1, characterised in that the lacquer (9) is poured in under pressure.

6. Method according to Claim 1, characterised in that excess lacquer (9) is drawn off by suction.

7. Apparatus for carrying out the method according to Claim 1, having a housing (2) for receiving a module consisting of electrical and/or mechanical components which incorporates, inter alia, a plug-and-socket connector (1), a conductor board (5) and power semiconductors (51),
– having a lower part (20) with a base (24), longitudinal walls (23) and transverse walls (231),
– having a recess in, or instead of, one of the longitudinal walls (23) in which the plug-and-socket connector (1) is seated, and
– having a lid (3),
characterised in that
– in the region of the recess, a crosspiece (4) extending between the transverse walls (231) forms, together with the base (24), the transverse walls (231) and a longitudinal wall (23), a trough in which the parts of the module to be lacquered are mounted.

8. Apparatus according to Claim 7, characterised in that
– the lid has a circumferential lid groove (31) filled with elastic sealing compound (311),
– the tops of the transverse and longitudinal walls (23, 231) have a circumferential rib (21) and the plug-and-socket connector (1) has a rib (11) at the point of contact with the lid (3), and
– said ribs (11, 21) project into the sealing compound (311).

9. Apparatus according to Claim 7, characterised in that
– the two longitudinal walls (23) each have two holding grooves (7) which run perpendicular to the base (24) and which are each equally spaced from the transverse walls (231),
– two spring holders (6) with springs (61) fit into the holding grooves (7) parallel to the transverse walls (231), and
– the springs (61) press the power semiconductors (51) against the transverse walls (231).

## Revendications

1. Procédé de vernissage d'un assemblage d'éléments (1;5;51) constitué d'éléments électriques et/ou mécaniques dans un boîtier, l'assemblage étant monté dans le boîtier (2) et comportant des parties à vernir et des parties à ne pas vernir,
caractérisé en ce qu'il consiste
– à disposer l'assemblage dans une partie du bottier en forme de cuvette de manière que les parties à vernir se trouvent en-dessous d'un niveau de vernissage de la partie du boîtier et les parties à ne pas vernir au-dessus de ce niveau,
– à emplir la partie du boîtier de vernis (9) jusqu'au niveau de vernissage, et
– à éliminer ensuite du vernis (9) en excès.

2. Procédé selon la revendication 1,
caractérisé en ce qu'il consiste
à secouer le boîtier (2) lors du remplissage du vernis.

3. Procédé selon la revendication 1,
caractérisé en ce qu'il consiste
à mettre le boîtier (2) sous vide lors du remplissage du vernis.

4. Procédé selon la revendication 1,
caractérisé en ce qu'il consiste
à soumettre la quantité de vernis chargée à l'action d'ultrasons.

5. Procédé selon la revendication 1,
caractérisé en ce qu'il consiste
à introduire le vernis (9) sous pression.

6. Procédé selon la revendication 1,
caractérisé en ce qu'il consiste
à aspirer du vernis (9) en excès.

7. Dispositif pour la mise en oeuvre du procédé suivant la revendication 1 comprenant un boîtier (2) de réception d'un assemblage constitué d'éléments électriques et/ou mécaniques, qui comporte entre autres un connecteur à enfichage (1), une plaquette de circuits imprimés (5) et des semiconducteurs de puissance (51) et qui comporte
– une partie inférieure (20) ayant un fond (24), des parois longitudinales (23) et des parois transversales (231),
– un évidement dans ou à la place de l'une des parois longitudinales (23), dans lequel est monté le connecteur à enfichage (1) et
– un couvercle (3),
caractérisé en ce que
– dans la région de l'évidement, une barrette (4) qui s'étend entre les parois transversales (231) forme, avec le fond (24), les parois transversales (231) et les parois longitudinales (23), une cuvette dans laquelle sont disposées les parties de l'assemblage à vernir.

8. Dispositif selon la revendication 7,
caractérisé en ce que
– le couvercle comporte une gorge de couvercle (31) faisant tout le tour et empli d'une masse élastique d'étanchéité (311),
– les côtés supérieurs des parois transversales et longitudinales (23, 231) possédant une nervure (21) faisant tout le tour et le connecteur à enfichage (1) présente, au point de contact avec le couvercle (3), une nervure (11), et

– ces nervures (11, 21) pénètrent dans la masse d'étanchéité (311).

9. Dispositif suivant la revendication 7 caractérisé en ce que

– les deux parois longitudinales (23) ont respectivement deux gorges de maintien (7) s'étendant perpendiculairement au fond et se trouvant respectivement à la même distance des parois transversales (231),

– parallèlement aux parois transversales (231), deux supports de ressorts (6) ayant des ressorts (61) sont enfichés dans les gorges de maintien (7) et

– les ressorts (61) poussent les semiconducteurs de puissance (51) contre les parois transversales (231).

FIG 1

FIG 4

FIG 5

# FIG 2

# FIG 3